# FASCICULE DE BREVET EUROPEEN

(11) **EP 2 101 332 B1**
(45) Date de publication et mention de la délivrance du brevet: **02.03.2011**
(21) Numéro de dépôt: 09154597.0
(22) Date de dépôt: 09.03.2009
(51) Int. Cl.: G11C 13/02

(54) **Dispositif de mémoire électrochimique non-volatile**
Nichtflüchtige elektrochemische Speichervorrichtung
Non-volatile electrochemical memory device

(30) Priorité: 13.03.2008 FR 0851631
(43) Date de publication de la demande: 16.09.2009
(73) Titulaire: Commissariat à l'Énergie Atomique et aux Énergies Alternatives, 75015 Paris (FR)
(72) Inventeur: Bloch, Didier, 38330, BIVIERS (FR); Bourbon, Carole, 38590, SAINT MICHEL DE SAINT GEOIRS (FR); Le Cras, Frédéric, 38470, NOTRE-DAME-DE-L'OSIER (FR); Nowodzinski, Antoine, 38000, GRENOBLE (FR)
(74) Mandataire: Ilgart, Jean-Christophe

(56) Documents cités:
- EP-A- 0 380 058
- EP-A- 1 892 723
- FR-A- 2 873 856
- FEI ZHOU, MATTEO COCOCCIONI, KISUK KANG AND GERBRAND CEDER: "The Li intercalation potential of LiMPO4 and LiMSiO4 olivines with M = Fe, Mn, Co, Ni" ELECTROCHEMISTRY COMMUNICATIONS, vol. 6, no. 11, 1 novembre 2004 (2004-11-01), pages 1144-1148, XP002505886 Cambridge, MA 02139, USA

## Description

### DOMAINE TECHNIQUE

L'invention est relative au domaine des mémoires et concerne une nouvelle technologie de mémoires que l'on nommera « NEMO's » pour « Nano Electrochemical MemOries ».

La présente invention prévoit la mise en oeuvre d'une cellule mémoire électrochimique non-volatile formée d'un empilement de couches minces comprenant au moins une première couche active, apte à libérer et/ou accepter, de manière réversible, au moins une espèce ionique, au moins une deuxième couche active, apte à libérer et/ou accepter, de manière réversible, ladite espèce ionique, ainsi qu'un électrolyte entre la première couche active et la deuxième couche active.

Les matériaux respectifs de la première couche active et de la deuxième couche active sont choisis en fonction de leurs profils de potentiels électrochimiques et ont des profils de potentiels électrochimiques différents.

Des moyens générateurs d'impulsions de courant pour modifier l'état de la cellule ainsi qu'une mesure de la différence de potentiel électrochimique entre la première couche active et la deuxième couche active afin de déterminer l'état de la cellule sont également prévus.

L'invention peut être intégrée en particulier dans de nombreux dispositifs électroniques, informatiques, terminaux de communications, appareils, équipements, nécessitant une mémoire. Elle permet la mise en oeuvre de mémoires électrochimiques ayant un encombrement faible, ainsi qu'une fiabilité, une sensibilité, et une rapidité, améliorées.

### ÉTAT DE LA TECHNIQUE ANTÉRIEURE

On cherche constamment à développer de nouveaux types de mémoires.

Un premier objectif poursuivi est la diminution de la taille des mémoires. Pour les dispositifs existants, tels que, par exemple, les DRAM (DRAM pour dynamic random access memory), SRAM (SRAM pour static random access memory), les mémoires flash, la réduction de taille implique généralement dans le même temps une détérioration de leurs performances.

Un deuxième objectif vise généralement à améliorer la consommation des mémoires, en particulier pour des applications à des équipements portables.

Parmi les types de mémoires existants, figure une structure de cellule mémoire appelée « PMC » (PMC pour « Programmable Metallization Cell » selon la terminologie anglo-saxonne) formée d'un empilement de couches comportant un électrolyte solide situé entre deux électrodes.

Une telle structure est décrite par exemple dans le document US 5,761,116. Le principe de fonctionnement des mémoires PMC repose sur la formation (respectivement la dissolution), au sein d'un électrolyte solide interposé entre deux électrodes polarisées, d'agrégats conducteurs électroniques qui viennent établir (respectivement supprimer) un contact entre ces deux électrodes. Un électrolyte solide à base d'un chalcogénure vitreux par exemple du Ge-S ou du Ce-Se, conducteur d'ions argent peut être utilisé. Cet électrolyte conducteur ionique et isolant électronique peut être placé entre deux électrodes, une par exemple en argent, et l'autre, inerte, en nickel par exemple. A l'état initial, aucun contact n'est établi entre les deux électrodes qui sont séparées par une zone isolante. Lorsqu'une tension de polarisation est appliquée entre les deux électrodes, l'électrode d'argent fournit des ions Ag+ qui traversent l'électrolyte et se déposent sur l'électrode opposée en constituant un dépôt d'argent métallique. Ce dépôt est appelé « dendrite ». Les dendrites métalliques croissent progressivement au sein du milieu électrolytique sous l'effet de la tension appliquée, puis, si la tension est maintenue, finissent par établir des ponts de conduction électronique entre les deux électrodes. Lorsque la tension imposée est diminuée, ou qu'une tension inverse est appliquée, les dendrites se dissolvent. L'électrolyte peut alors à nouveau jouer son rôle d'isolant.

Un inconvénient de ce type de mémoire est qu'il est difficile de passer très rapidement d'un état à un autre état de la mémoire.

Par ailleurs, au bout d'un certain nombre de cycles d'écriture/effacement de la mémoire, des dépôts dendritiques constitués par de l'argent métallique peuvent être simultanément présents sur les deux électrodes. Au bout d'un certain nombre de cycles effacement/écriture, le milieu électrolytique entre les deux électrodes peut être gorgé d'agrégats métalliques isolés, de sorte que la fiabilité des opérations d'écriture et d'effacement est remise en cause.

Une autre structure de cellule mémoire est présentée dans le document US 6,864,522 B2. Une telle structure comprend, de part et d'autre d'une couche « barrière » : une couche active présentant une conductivité électrique variable en fonction de son état « dopé » ou « non dopé » par des espèces chargées, une couche passive contenant les espèces chargées et permettant, lorsqu'une différence de potentiel est appliquée entre les deux électrodes, d'engendrer un processus destiné à faire varier la conductivité électrique de l'électrode active. Deux états « haute impédance » et « faible impédance » sont susceptibles d'être obtenus en appliquant, aux bornes de la structure, une tension électrique supérieure à une valeur appelée « tension de seuil ».

Le principe de fonctionnement d'une telle structure est ainsi fondé sur une variation de conductivité électrique d'un matériau dopé par des espèces chargées.

Cette variation est en réalité une valeur moyenne de conductivité de l'électrode et constitue une grandeur macroscopique.

Une telle structure de cellule mémoire a un fonctionnement volatil.

Un autre dispositif de mémoire électrochimique à fonctionnement volatil est donné dans le document EP 1 892 723 A. Ce dispositif est doté moyens générateurs destiné à injecter du courant à un empilement de couches comportant un électrolyte et, de part et d'autre des couches actives à base d'un matériau cristallin conducteur ionique et électronique tel que du LiMn₂O₄.

Il se pose le problème de trouver un nouveau dispositif de cellule mémoire électrochimique ne comportant pas les inconvénients mentionnés ci-dessus, plus sensible que les mémoires électrochimiques basées sur la variation de conductivité des électrodes, et ayant un comportement non-volatil.

### EXPOSÉ DE L'INVENTION

L'invention concerne un dispositif de mémoire électrochimique non-volatile selon la revendication 1.

Un tel dispositif de mémoire non volatile présente au moins deux niveaux de potentiels stables, mesurables et distincts.

Un tel dispositif ne perd pas son information ou ses informations stockées après extinction de son alimentation.

Un tel dispositif est susceptible d'effectuer des processus d'écriture et d'effacement rapides, et présente également une bonne sensibilité.

Un tel dispositif est fiable dans le temps, et susceptible de présenter une longue durée de vie.

Certaines technologies selon l'art antérieur reposent sur la mesure d'une variation de conductivité électrique d'un matériau d'électrode sous l'effet d'un dopage en espèces chargées.

Dans le dispositif suivant la présente invention, on exploite des variations de potentiels électrochimiques des électrodes sous l'effet de faibles variations de la composition des matériaux d'électrodes.

Un dispositif suivant l'invention met en oeuvre une mesure plus précise qu'un système fondé uniquement sur des variations de conductivité électrique d'une électrode.

Le premier matériau et le deuxième matériau peuvent être des composés différents d'intercalation du lithium. Ainsi, ladite espèce ionique peut être des ions lithium.

La première couche active peut être choisie de manière à avoir un profil de potentiel électrochimique destiné à varier, entre au moins un premier potentiel et au moins un deuxième potentiel, tandis que la deuxième couche de matériau est choisie de manière à avoir un profil de potentiel électrochimique compris entre le premier potentiel et le deuxième potentiel.

Les moyens générateurs peuvent être prévus pour injecter des impulsions de courant selon une durée et une amplitude données de manière à appliquer audit empilement une quantité d'électricité donnée comprise entre 10 µA*nanosecondes et 500 µA*nanosecondes.

Des impulsions de courant de durée comprise par exemple entre 10 nanosecondes et 50 nanosecondes et d'intensité comprise par exemple entre 1 et 10 µA peuvent être prévues, par exemple pour des électrodes de diamètre ou dimension critique de l'ordre de 50 nanomètres.

Par dimension critique d'une électrode, on entend la plus petite dimension de cette électrode autre que l'épaisseur du bloc ou de la couche ou de l'empilement de couches à base duquel (de laquelle) cette électrode est formée.

Le dispositif de mémoire non-volatile suivant l'invention présente une bonne réversibilité.

Pour permettre de faire basculer la mémoire d'un premier état à un deuxième état, les moyens générateurs peuvent être prévus pour appliquer au moins une impulsion de courant, tandis qu'au moins une autre impulsion de courant opposée et éventuellement d'amplitude égale à celle de ladite impulsion peut permettre de faire basculer la mémoire du deuxième état à un premier état.

L'électrolyte choisi peut être un électrolyte vitreux présentant une bonne imperméabilité au passage des électrons, de manière à obtenir une bonne rétention de l'information stockée.

Ladite deuxième variation peut être une variation nulle ou faible, c'est à dire au moins inférieure à 1 mV ou à 30 mV, pour une quantité d'électricité donnée injectée comprise entre 10 µA*nanosecondes et 500 µA*nanosecondes.

Ladite première variation peut être une variation importante, c'est à dire au moins supérieure à 100 mV ou à 200 mV ou à 400 mV, pour une quantité d'électricité donnée injectée comprise entre 10 µA*nanosecondes et 500 µA*nanosecondes.

La deuxième couche active peut être destinée à présenter une variation de potentiel inférieure ou égale à 1 mvolt ou à 30 mvolts pour une variation de la proportion de Li par rapport à M' (x2/y2) dans le Liₓ₂M'_{y2}O_{z2} comprise entre 1 % et 10 % avec M un élément métallique. L'élément M' peut être par exemple du Fe.

Selon une possibilité de mise en oeuvre du dispositif de mémoire dans laquelle les moyens générateurs sont prévus pour appliquer au moins une quantité d'électricité donnée comprise entre 10⁻⁹ µA*s et 10⁻⁷ A*s, la première couche active peut être destinée à présenter une variation de potentiel d'au moins 0,1 volts ou 0,2 volts ou comprise entre 0,1 et 0,4 volts.

La première couche active, lorsqu'elle est à base de Liₓ₁M_{y1}O_{z1} peut être destinée à présenter une variation de potentiel supérieure ou égale à 0,1 1 volts ou à 0,2 volts ou comprise entre 0,1 et 0,4 volts, pour une variation de la proportion de Li par rapport à M (x1/y1) dans le Liₓ₁M_{y1}O_{z1} comprise entre 1 % et 10 %.

L'élément M peut être par exemple du Mn.

Selon une possibilité de mise en oeuvre, ladite première couche active peut avoir un volume compris entre 3,125*10⁻⁴ µm³ et 0,1 µm³.

Selon une possibilité de mise en oeuvre, ladite deuxième couche active peut avoir un volume compris entre 3,125*10⁻⁴ µm³ et 0,1 µm³.

Une cellule mémoire compacte peut être ainsi mise en oeuvre.

Selon une possibilité, le premier matériau peut être à base d'un composé de type spinelle tel que du LiMn₂O₄ ou du LiNi_{0.5}Mn_{1.5}O₄.

Selon une autre possibilité, le premier matériau peut être à base d'un composé de type olivine tel que du LiₓFe₁₋ₓMnₓPO₄ ou du LiₓFe₁₋ₓCOₓPO₄.

Selon une autre possibilité, le premier matériau peut être à base d'un mélange d'au moins un composé sous forme réduite et d'au moins un composé sous forme oxydée.

Le premier matériau peut être à base d'un mélange de α·LiFePO₄ et de 1-α·LiTiCrO₄ ou d'un mélange de α·LiFePO4 et de 1-α·Li_{4/3}Ti_{5/3}O₄ ou d'un mélange de α·LiVPO₄F et 1-α·L1_{4/3}Ti_{5/3}O₄ ou d'un mélange de α·LiVPO₄F et de 1-α·Fe₂(MoO₄)₃ ou d'un mélange de α·LiNi_{0.5}Mn_{1.5}O₄ et 1-α·εVOPO₄.

Selon plusieurs possibilités, les couples suivants de matériaux peuvent être prévus pour les première et deuxième couches actives :
- le premier matériau peut être à base de LiNi_{0.5}Mn_{1.5}O₄, le deuxième matériau étant à base de Li₁₋ₓVOPO₄F ou de Li₁₋ₓFePO₄,
- le premier matériau peut être à base de LiFe₁₋ₓCoₓPO₄ tandis que le deuxième matériau est à base de Li₁₋ₓVOPO₄F,
- le premier matériau peut être à base d'un mélange de LiFePO₄ et de Li₄Ti₅O₁₂, le deuxième matériau étant à base de α·Fe₂(MoO₄)₃.

Le dispositif de mémoire peut comprendre en outre, au moins une couche métallique en contact avec la première couche active et/ou au moins une autre couche métallique en contact avec la deuxième couche active.

Selon une possibilité, le dispositif de mémoire peut comprendre en outre : des moyens de mesure de la différence de potentiel électrochimique entre ladite première couche active et ladite deuxième couche active. Ces moyens de mesure de différence de potentiel électrochimique peuvent comprendre des moyens formant un voltmètre.

Ce type de cellule est plus sensible qu'un système fondé uniquement sur les variations de conductivité électrique d'une électrode.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre un exemple de cellule mémoire non-volatile suivant l'invention, comprenant une première couche active et une deuxième couche active formées de matériaux différents et situées de part et d'autre d'un électrolyte,
- la figure 2 représente un exemple de courbe de potentiel électrochimique d'un matériau Li_{1+Δδ}Mn₂O₄, mesuré par rapport à une électrode de référence en Li en fonction du rapport atomique Li/Mn, et formant la première couche active dans un exemple de cellule mémoire non-volatile suivant l'invention,
- la figure 3 représente une courbe de potentiel électrochimique d'un matériau Liₓ[Ni_{1/2}Mn_{3/2}O₄], mesuré par rapport à une électrode de référence en Li en fonction de la concentration en Li, et formant le matériau de la première couche active dans un autre exemple de cellule mémoire non-volatile suivant l'invention,
- la figure 4 représente des exemples de profils de potentiels électrochimiques du matériau d'une première couche active et du matériau d'une deuxième couche active dans un exemple de cellule mémoire suivant l'invention,
- la figure 5 représente une courbe de potentiel électrochimique d'un matériau LiFePO₄, formant le matériau de la deuxième couche active dans un exemple de cellule mémoire non-volatile suivant l'invention,
- la figure 6 représente une courbe de potentiel électrochimique d'un matériau Li (Mn_{0.6}Fe_{0.4}PO₄), formant le matériau de la deuxième couche active dans un autre exemple de cellule mémoire non-volatile suivant l'invention,
- la figure 7 représente une courbe de potentiel électrochimique d'un matériau Li₁₋ₓVPO₄F, mesuré par rapport à une électrode de référence en Li en fonction de la concentration en Li, et formant le matériau de la deuxième couche active dans un autre exemple de cellule mémoire non-volatile suivant l'invention,
- la figure 8 représente un exemple de courbe de potentiel électrochimique d'un matériau Li₁₋ₓVPO₄F formant la deuxième couche active dans un autre exemple de cellule mémoire suivant l'invention,
- la figure 9 donne des courbes de charge et de décharge du LiFe₁₋ₓCoₓPO₄,
- la figure 10 donne des courbes d'évolution du potentiel électrochimique du LiₓVOPO₄F et du Li₁₊ₓNi_{0.5}Mn_{1.5}O₄.
- la figure 11 donne des courbes d'évolution de potentiel d'un exemple de cellule mémoire suivant l'invention.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

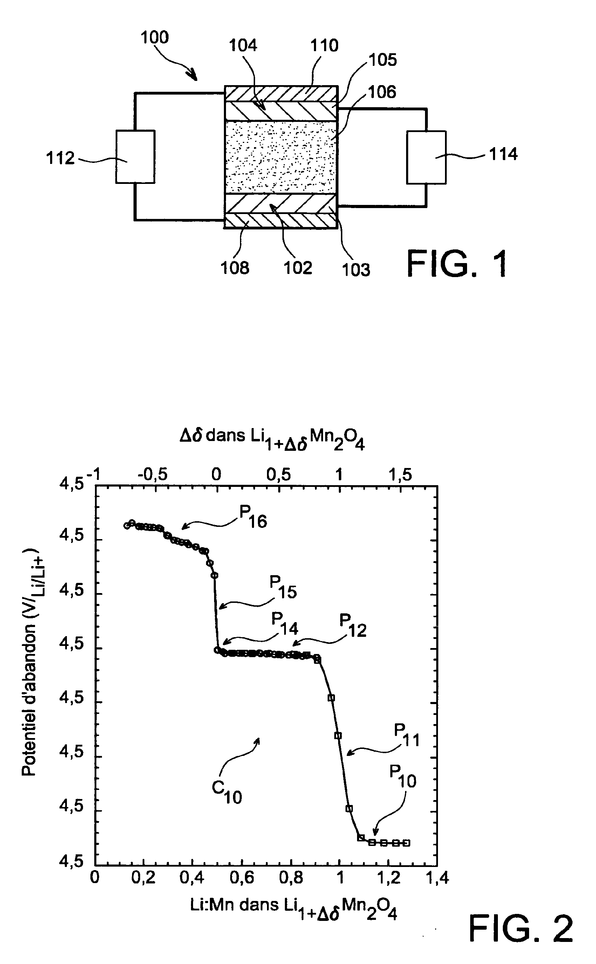

Un exemple de dispositif de cellule mémoire électrochimique non-volatile selon l'invention est illustré sur la figure 1.

Ce dispositif 100 comprend des moyens générateurs 112 ainsi qu'un empilement de couches minces comportant une première couche 102 dite « active » ou que l'on appellera également première électrode, à base d'un premier matériau 103 cristallin conducteur ionique et électronique, apte à contenir au moins une espèce ionique et d'autre part à libérer et/ou accepter, de façon réversible, cette espèce ionique.

La première couche 102 active peut être à base d'au moins un composé d'intercalation comportant un oxyde de métal de transition. Le premier matériau 103 est choisi en fonction de son profil de potentiel électrochimique.

Le premier matériau 103 peut être un composé d'intercalation du lithium, apte à libérer et à accepter dans sa structure, de manière réversible, des ions Li+. Dans ce cas, le premier matériau 103 est choisi notamment en fonction de son profil de potentiel d'insertion et d'extraction (ou désinsertion) du lithium.

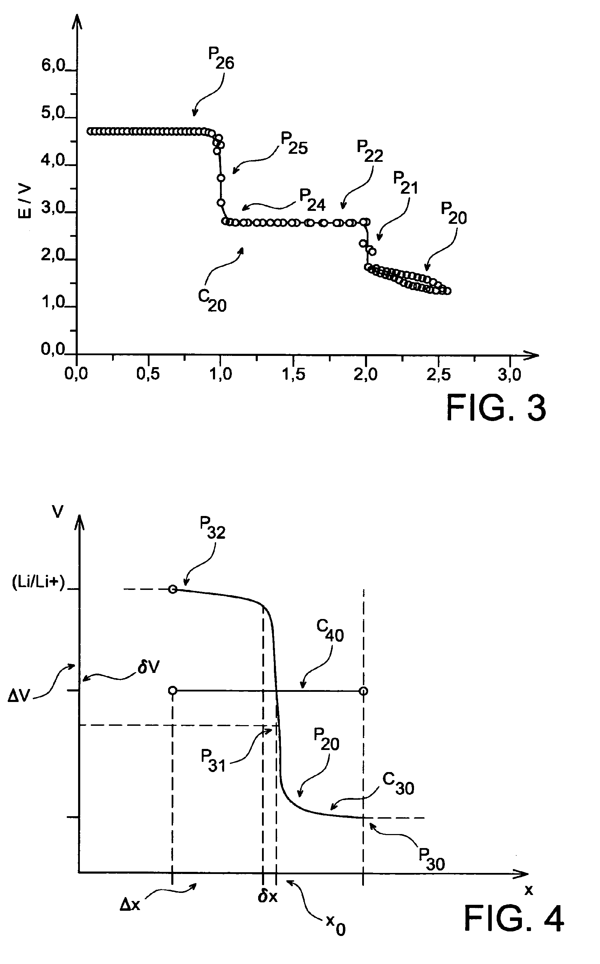

La première couche active 102 peut être à base d'un composé d'intercalation du lithium, dont le profil de potentiel électrochimique peut être du type de celui illustré par la courbe C₃₀ de la figure 4. Le matériau de la première couche active peut être choisi de sorte que sous l'effet d'une faible variation δx de composition ou de concentration en espèce chargée au voisinage d'une composition donnée du matériau 103, cette couche active 102 est susceptible de présenter une importante variation ΔV de potentiel électrochimique.

La première couche active 102 est mise en oeuvre avec un matériau 103 choisi de manière à présenter un profil de potentiel d'insertion/extraction du lithium avec au moins deux niveaux de potentiels (paliers P₃₀ et P₃₂ sur la courbe C₃₀) électrochimiques bien distincts de part et d'autre d'une composition initiale, ainsi qu'une zone de transition abrupte (portion P₃₁ de la courbe C₃₀) entre un premier niveau de potentiel électrochimique (palier P₃₀) et un deuxième niveau de potentiel électrochimique (palier P₃₂).

La première couche active peut être destinée à présenter une variation de potentiel supérieure ou égale à 0,1 1 V ou à 0,2 V ou comprise entre 0,1 V et 0,4 V, pour une quantité d'électricité appliquée par les moyens générateurs 112 comprise entre 10 µA*ns et 500 µA*ns.

Le composé d'intercalation de la première couche active 102 peut être un oxyde de métal de transition lithié par exemple un oxyde de manganèse lithié LiₓMn_{y}O_{z} (avec x, y, z des nombres entiers) tel que du LiMn₂O₄, ayant une structure spinelle stoechiométrique.

Le matériau 103 d'intercalation de la couche active 102, peut être de formule générale Liₓ₁M_{y1}O_{z1}, et choisi de sorte que la première couche active présente une variation de potentiel au moins égale ou supérieure à 0,1 volts ou au moins égale ou supérieure à 0,2 volts pour une variation de la proportion de Li par rapport à M (x1/y1) dans le matériau 103 à base de Liₓ₁M_{y1}O_{z1}, comprise entre 1 % et 10 %.

Par exemple, une couche active 102 à base de LiMn₂O₄ est susceptible de présenter une importante variation de potentiel électrochimique sous l'effet d'une faible variation de composition ou de concentration en ions Li⁺.

Sur la figure 2, une courbe C₁₀ de potentiel électrochimique du Li_{1+Δδ}Mn₂O₄, par rapport à une électrode de référence de lithium métallique, en fonction de la fraction Δδ de Li est donnée.

Selon un exemple, lorsque la première couche active 102 a une autre composition initiale telle que Δδ = 0, i.e. est à base de LiMn₂O₄, elle présente un profil de potentiel d'insertion/extraction du lithium avec deux niveaux de potentiels électrochimiques bien distincts (portions P₁₂ et P₁₆ de la courbe C₁₀) de part et d'autre d'une autre composition initiale, ainsi qu'une zone de transition abrupte (portion P₁₅ de la courbe C₁₀) entre lesdits deux autres niveaux de potentiels électrochimiques.

Une quantité d'électricité prédéterminée appliquée par les moyens générateurs 112 peut permettre de faire passer le matériau de la première couche active 102 d'un niveau P₁₂ de potentiel à l'autre niveau P₁₆.

Le choix du matériau 103, en fonction des critères précités pour la première couche active 102, peut être effectué par exemple à l'aide de tests expérimentaux. Le potentiel d'insertion/désinsertion du lithium dans des composés à base de métaux de transition dépend en particulier des couples de métaux M^{*n+1*+}/M^{*n*+} considérés, des anions composants leur environnement proche (oxygène, soufre, sélénium ou polyanions à base de Si, P, S, Ge, As...), et de la configuration spatiale de cet environnement comme cela est indiqué dans le document de T. Ohzuku, et A. Ueda, Solid State Ionics 69 (1994) 201-211, dans le cas d'oxydes simples. Des données expérimentales de potentiels d'extraction et désinsertion du lithium pour les composés de métaux de transition, tels que des dioxydes simples, peuvent être utilisées afin de choisir le matériau de la première couche active en fonction de l'évolution de son potentiel électrochimique. Un tel choix peut être également fait à l'aide de données de simulations ou/et données obtenues par calculs. On peut notamment réaliser une évaluation des potentiels d'intercalation par le calcul de d'énergie libre de Gibbs à l'aide de méthodes appliquant la théorie de la fonctionnelle de densité (DFT), par exemple telle que celles décrites dans le document de Ceder et al. Electrochem. Comm. 6 (2004) 1144-1148, pour des composés de type olivine LiMPO₄ et LiMSiO₄.

D'autres exemples de composés ou mélanges de composés répondant aux critères précités peuvent être également utilisés pour former la première couche active 102.

Un composé de type spinelle et présentant deux processus d'intercalation/désintercalation bien distincts en potentiels, tel que le LiNi_{0.5}Mn_{1.5}O₄, peut par exemple être utilisé pour former la première couche active 102.

Sur la figure 3, une courbe C₂₀ de potentiel électrochimique d'une couche active à base de Liₓ[Ni_{1/2}Mn_{3/2}]O₄ en fonction de la fraction x est donnée.

Lorsque cette couche active a par exemple une composition initiale telle que x = 2, i.e. que la première couche active est à base de Li₂[Ni_{1/2}Mn_{3/2}]O₄, elle présente un profil de potentiel d'insertion/extraction du lithium avec deux niveaux de potentiels électrochimiques bien distincts (portions P₂₀ et P₂₂ de la courbe C₂₀) de part et d'autre d'une composition initiale, ainsi qu'une zone de transition abrupte (portion P₂₁ de la courbe C₂₀) entre lesdits deux niveaux de potentiels électrochimiques.

Le Li₂[Ni_{1/2}Mn_{3/2}]O₄ peut être ainsi utilisé comme matériau 103 de la première couche active 102.

Selon un autre exemple, lorsque la couche active a une composition initiale telle que x = 1, i.e. est à base de Li[Ni_{1/2}Mn_{3/2}]O₄, elle présente un profil de potentiel d'insertion/extraction du lithium avec deux autres niveaux de potentiels électrochimiques bien distincts (portions P₂₄ et P₂₆ de la courbe C₂₀) de part et autre d'une composition initiale, ainsi qu'une zone de transition abrupte (portion P₂₅ de la courbe C₂₀) entre lesdits deux autres niveaux de potentiels électrochimiques. Le Li[Ni_{1/2}Mn_{3/2}]O₄ peut être ainsi utilisé comme matériau 103 de la première couche active 102.

Selon une autre possibilité, un composé de type olivine présentant deux processus d'intercalation/désintercalation bien distincts en potentiels, peut être utilisé pour former la première couche active 102. Un composé de type olivine tel que par exemple du LixFe₁₋ₓMnxPO₄ ou du LiₓFe₁₋ₓCoₓPO₄ (avec x ≠ 0) peut être utilisé.

Selon une variante, un mélange de deux composés dont les valeurs respectives de potentiel d'intercalation/désintercalation du lithium sont nettement différentes et qui comprend initialement un composé sous sa forme réduite et l'autre sous sa forme oxydée peut être utilisé pour former la première couche active. Les composés intercalant/désintercalant le lithium suivant un processus biphasé permettent avantageusement d'obtenir une rupture du profil potentiel plus nette de part et d'autre de la composition initiale.

La première couche active 102 peut être ainsi par exemple à base d'un mélange de α·LiFePO₄ et de 1-α·LiTiCrO₄ ou par exemple à base d'un mélange de α·LiFePO₄ et 1-α·Li_{4/3}Ti_{5/3}O₄ ou par exemple à base d'un mélange de α·LiVPO₄F et 1-α·Li_{4/3}Ti_{5/3}O₄ ou par exemple à base d'un mélange de α·LiVPO₄F et 1-α·Fe₂(MoO₄)₃ ou par exemple à base d'un mélange de α·LiNi_{0.5}Mn_{1.5}O₄ et (1-α)·εVOPO₄.

La première couche 102 peut avoir une épaisseur au moins inférieure à 1000 nm, comprise par exemple entre 10 nanomètres et 200 nanomètres, par exemple entre 25 nanomètres et 100 nanomètres.

La première couche active peut avoir un volume compris entre 3,125*10⁻⁴ µm³ et 0,1 µm³.

Une première électrode de petite taille peut être ainsi avantageusement mise en oeuvre.

Les moyens générateurs 112 sont prévus pour appliquer des quantités données prédéterminées d'électricité à l'empilement de couches de la cellule mémoire.

Les quantités d'électricité prédéterminées que les moyens générateurs 112 sont susceptibles d'appliquer peuvent être comprises entre 10 µA*nanosecondes et 500 µA*nanosecondes. Les impulsions de courant émises par les moyens 112 générateurs de courant peuvent être des impulsions d'intensité faible comprises par exemple entre 1 µA et 10 µA pendant une durée par exemple comprise entre 10 ns et 50 ns. Des impulsions d'intensité de l'ordre de 10⁻⁷ A pendant une durée de l'ordre d'une seconde peuvent être émises par exemple pour faire basculer la cellule mémoire d'un état à un autre état.

Les moyens générateurs 112 peuvent être prévus pour émettre des impulsions de courant selon au moins une durée et au moins une amplitude prédéterminées prévus pour faire varier le potentiel électrochimique de la première couche active de la cellule, entre, au moins une première valeur de potentiel électrochimique ou un premier palier de potentiel électrochimique, et au moins une deuxième valeur ou un deuxième palier de potentiel électrochimique.

Les impulsions de courant peuvent être prévues avec au moins une durée et au moins une amplitude prédéterminées prévues en fonction d'une fenêtre ou d'une gamme de concentration en ions Li+ dans laquelle on souhaite faire varier les matériaux des couches actives ou des électrodes de la cellule.

La gamme de fonctionnement ou de potentiels électrochimiques que la première couche active est destinée à adopter, peut dépendre notamment, d'une composition initiale x₀ du matériau de la première couche active 102 avant que la cellule soit mise en fonctionnement et polarisée, du volume de matériau actif dans cette couche, et des quantités d'électricité destinées à être appliquées par les moyens générateurs 112.

Ainsi, on peut prévoir la gamme de fonctionnement ou de potentiels électrochimiques que la première couche active est destinée à adopter, notamment en choisissant un volume d'électrode ou de quantité de matériau d'électrode et en ajustant la quantité d'électricité appliquée par les moyens générateurs 112.

L'empilement de couches minces comporte également une deuxième couche 104 dite « active » également appelée deuxième électrode, à base d'un deuxième matériau 105 cristallin conducteur ionique et électronique, apte à contenir au moins une espèce ionique et d'autre part, à libérer et/ou accepter cette espèce ionique.

La cellule est mise en oeuvre de manière à éviter une autodécharge et par là même, un effacement de son état mémoire. Les matériaux sont choisis de telle manière que l'extraction de lithium du matériau présentant le potentiel le plus bas (par exemple 3V pour le Liman₂O₄) n'est pas possible dans les conditions du présent assemblage car le matériau présentant le potentiel le plus élevé (par exemple le LiFePO₄ avec 3,45 V) a un potentiel insuffisant pour permettre l'extraction des ions lithium du matériau présentant le potentiel le plus faible. L'autodécharge est également par ailleurs évitée grâce à l'utilisation d'un l'électrolyte étanche à la conduction électronique.

Le deuxième matériau 105 est ainsi un matériau différent du premier matériau, ayant en particulier, un comportement différent de celui du premier matériau 103, lorsqu'une quantité d'électricité donnée prédéterminée, par exemple sous forme d'impulsions de courant d'amplitude et de durée prédéterminées, est appliquée par les moyens générateurs 112.

Le deuxième matériau 105 peut être un composé d'intercalation du lithium, apte à libérer et accepter dans sa structure, de manière réversible, des ions Li+. Le deuxième matériau 105 peut être également choisi en fonction de ses potentiels d'insertion et d'extraction ou de désinsertion du lithium.

La deuxième couche active 104 peut être à base d'un composé d'intercalation du lithium choisi de sorte, que sous l'effet d'une importante variation de composition ou de concentration en espèce chargée au voisinage d'une composition donnée du matériau, induite par l'application de ladite quantité d'électricité donnée par les moyens générateurs 112, ce matériau présente une faible variation de potentiel électrochimique.

La deuxième couche active 104 est mise en oeuvre avec un matériau 105 choisi de manière à présenter un profil de potentiel d'insertion/extraction du lithium avec des niveaux de potentiels électrochimiques proches de part et d'autre d'une composition initiale, ainsi qu'une zone de transition de pente nulle ou de faible pente entre lesdits niveaux de potentiels électrochimiques.

La deuxième couche active peut être prévue de sorte que suite à une injection d'une quantité d'électricité donnée dans ledit empilement, le potentiel électrochimique de cette dernière varie entre au moins une troisième valeur et au moins une quatrième valeur donnée, selon une deuxième variation plus faible que celle de la première couche active qui varie entre une première valeur et une deuxième valeur de potentiels électrochimiques.

Lesdites troisième valeur et quatrième valeur peuvent être situées entre la première valeur et ladite deuxième valeur.

Un tel profil de potentiel électrochimique de la deuxième couche active 104, peut être par exemple tel que celui illustré sur la courbe C₄₀ de la figure 4. Le matériau de la deuxième couche active 104 est choisi de sorte, que sous l'effet d'une importante variation ΔX de composition ou de concentration en espèce chargée au voisinage d'une composition donnée du matériau 105, cette couche 102 présente une variation faible δV ou nulle de potentiel électrochimique.

Le deuxième matériau 105 peut être choisi en fonction de son profil de potentiel d'insertion/extraction du lithium, de manière à avoir un profil de potentiel situé entre les deux niveaux extrêmes (paliers P₃₀ et P₃₂ de la courbe C₃₀ sur la figure 4) de potentiels que la première couche active 102 est destinée à adopter.

Les compositions des matériaux des couches actives 102 et 104, quantité de matériau de ces couches 102, 104, et quantité d'électricité administrées par les moyens générateurs 112 sont choisis de sorte que le potentiel électrochimique de la deuxième couche active 104 est toujours situé entre les deux niveaux extrêmes (paliers P₃₀ et P₃₂ de la courbe C₃₀ sur la figure 4) de potentiels que la première couche active 102 est destinée à adopter.

La deuxième couche active 104 peut être à base d'un matériau 105 susceptible de présenter une variation de potentiel inférieure ou égale à 1 mvolt ou à 30 mvolts, pour une variation en concentration de ladite espèce ionique comprise entre 1 % et 10 % La deuxième couche active peut être à base d'un matériau susceptible de présenter une variation de potentiel inférieure ou égale à 1 mV ou à 30 mV pour une quantité d'électricité appliquée par les moyens générateurs 112 comprise entre 10 µA*ns et 500 µA*ns.

Le deuxième matériau 105 peut avoir un profil de potentiel électrochimique sous la forme d'un plateau de potentiel ou d'une courbe à faible pente (courbe C₄₀ sur la figure 4 de profil de potentiel du deuxième matériau dans un exemple de cellule suivant l'invention) dans la zone considérée de composition du deuxième matériau, déterminée en fonction d'une composition initiale de la deuxième couche active 104 et une quantité d'électricité que les moyens 112 sont destinés à appliquer.

Dans son état initial, la deuxième couche active 104 a une composition prévue de manière à permettre l'insertion de lithium provenant de la première couche active 102.

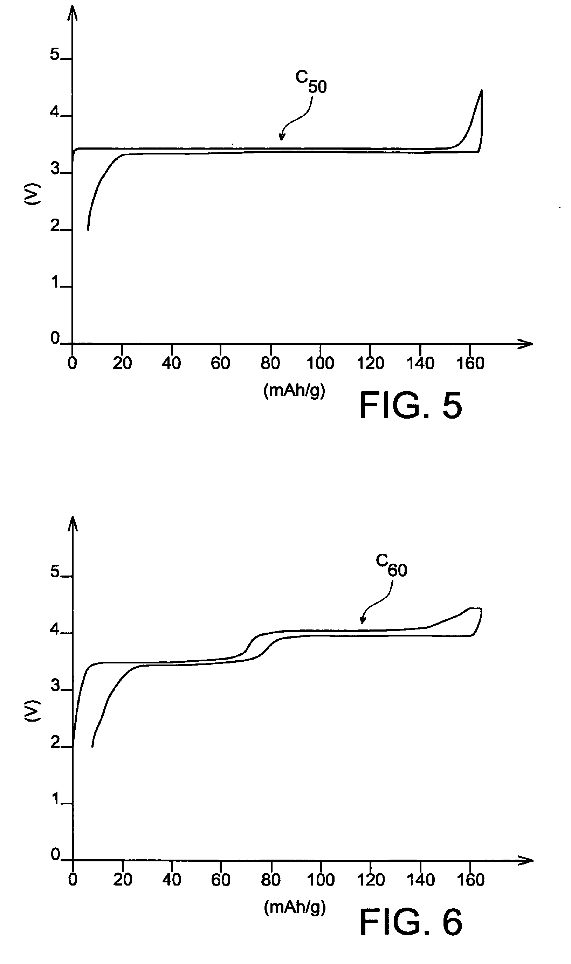

Sur la figure 5, un exemple de courbe C₅₀ de potentiel électrochimique du LiFePO₄ est donné. Le LiFePO₄ peut être utilisé comme matériau pour former la deuxième électrode.

Selon un autre exemple, le deuxième matériau 105 peut être à base de Li(Mn_{0.6}Fe_{0.4})PO₄. Sur la figure 6, un exemple de courbe C₆₀ de potentiel d'un tel matériau est donné.

Selon un autre exemple, le deuxième matériau 105 peut être du Li₁₋ₓVOPO₄F.

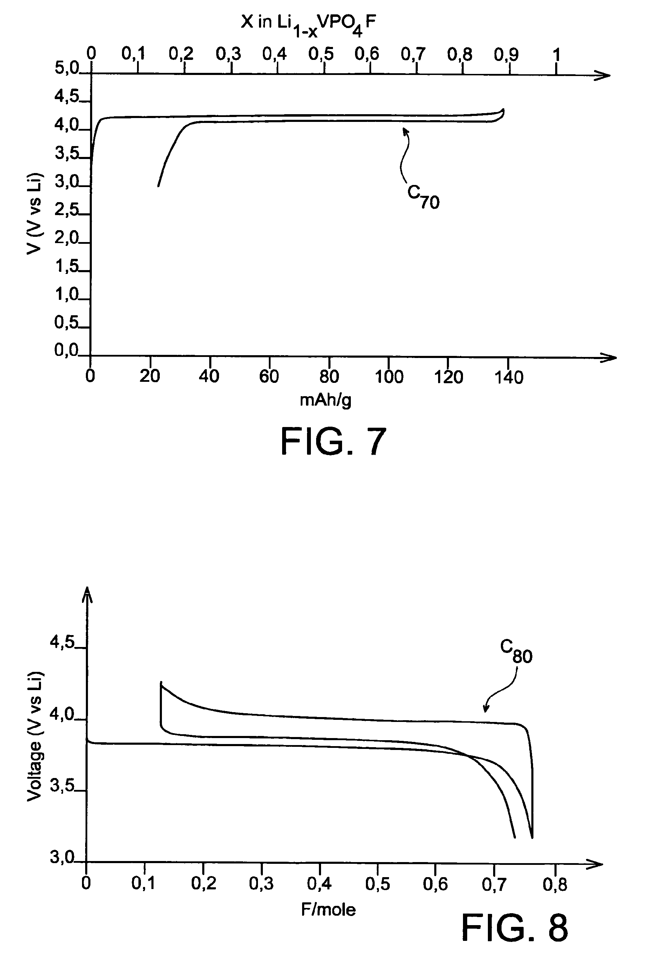

Sur la figure 7, un exemple de courbe C₇₀ de potentiel du Li₁₋ₓVOPO₄F mesurée par rapport à une électrode de référence en Li, en fonction d'une fraction x en Lithium est donnée.

Sur la figure 8, un exemple de courbe C₈₀ de potentiel électrochimique du ε-VOPO₄ par rapport à une électrode de lithium de référence, en fonction de la capacité de cette électrode est donnée.

La deuxième couche 104 active peut avoir une épaisseur au moins inférieure à 1000 nm, comprise par exemple entre 10 nanomètres et 200 nanomètres ou entre 25 nanomètres et 100 nanomètres.

La deuxième couche active peut avoir un volume compris entre 3,125*10⁻⁴ µm³ et 0,1 µm³.

L'utilisation d'une faible quantité de matériau dans les électrodes permettra de limiter les processus de diffusion d'une part, et d'autre part de limiter la quantité de courant nécessaire à la variation de composition des électrodes induisant le basculement de la mémoire.

Le choix d'un matériau pour la deuxième couche active répondant aux critères précités, peut être réalisé par exemple à l'aide de tests expérimentaux ou d'une méthode de prédiction, tel que cela a été indiqué précédemment pour le premier matériau.

Plusieurs exemples de couples de matériaux pour former la première couche active 102 et la deuxième couche active 104 vont à présent être donnés.

Le deuxième matériau 105 peut être du Li₁₋ₓVOPO₄F ou du Li₁₋ₓFePO₄, dans un cas, où le premier matériau 103 est à base de LiNi_{0.5}Mn_{1.5}O₄.

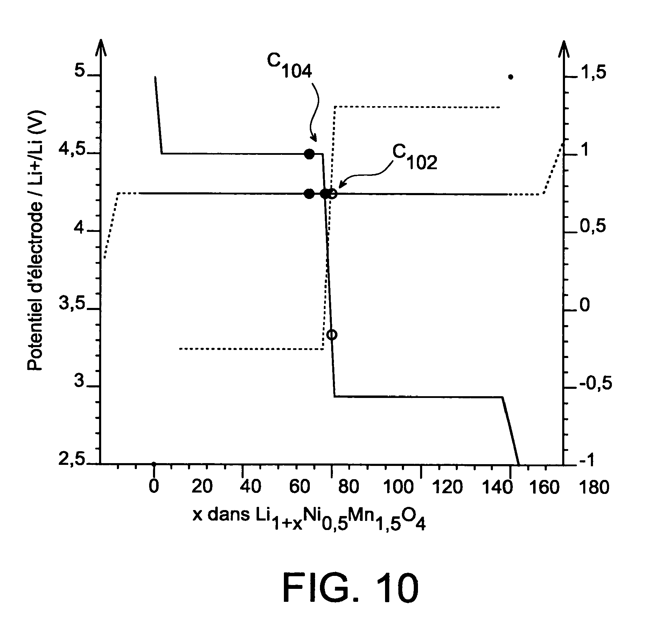

Sur la figure 10, des courbes C₁₀₂ et C₁₀₄ d'évolution du potentiel électrochimique du LiₓVOPO₄F et du Li₁₊ₓNi_{0.5}Mn_{1.5}O₄, sont données.

Selon d'autres possibilités, le deuxième matériau 105 peut être du Li_{1-X}VOPO₄F ou du Li₁₋ₓFePO₄ dans un cas où le premier matériau 103 est à base de LiMn₂O₄.

Le deuxième matériau 105 peut être, par exemple, à base de Li₁₋ₓVOPO₄F dans un cas où le premier matériau 103 est à base de LiFe₁₋ₓCoₓPO₄.

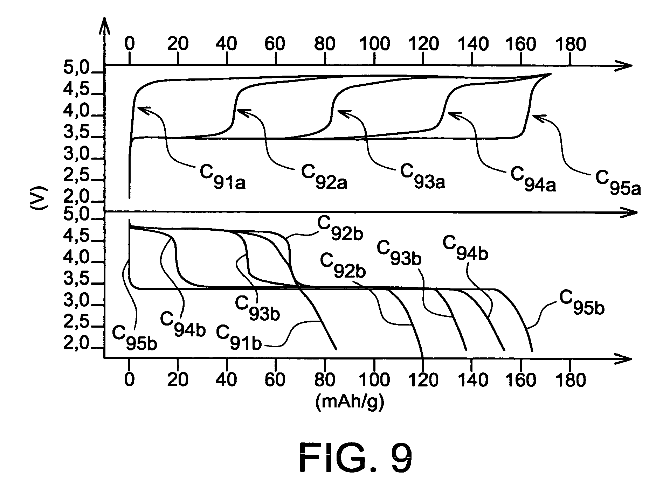

La figure 9 donne des courbes C₉₁ₐ, C₉₂ₐ. C₉₃ₐ, C₉₄ₐ, C₉₅ₐ, de charge du LiFe₁₋ₓCOₓPO₄ respectivement pour x=1, x=0.8, x=0.5, x=0.2, x=0, ainsi que des courbes C_{91b}, C_{92b}, C_{93b}, C_{94b,} C_{95b}, de décharge du LiFe₁₋ₓCoₓPO₄ respectivement pour x=1, x=0.8, x=0.5, x=0.2, x=0.

Le deuxième matériau 105 peut être à base de α·Fe₂(MoO₄)₃, tandis que la première électrode 102 est une électrode mixte à base de LiFePO₄ et de Li₄Ti₅O₁₂.

D'autres choix possibles de couples de matériaux vérifiant les propriétés et critères de choix précités peuvent être effectués. Des conditions de sensibilité, c'est-à-dire permettre un basculement de la mémoire grâce à une faible valeur d'impulsion de courant et de rapidité, c'est-à-dire une vitesse de basculement d'un état à l'autre de la mémoire peuvent notamment dicter le choix de ces couples de matériaux d'électrodes, tout en restant dans des critères tels que ceux précités en ce qui concerne les profils d'évolution de potentiel électrochimique.

Une couche ou un empilement de couches formant un électrolyte 106 sépare la première couche 102 active de la deuxième couche 104 active.

L'électrolyte 106 peut être formé par exemple d'un matériau conducteur ionique et isolant électronique, par exemple un verre de type « Lipon^{®}» ou de composition : 1B₂O₃-0,8Li₂O-0,8Li₂SO₄. Selon d'autres exemples, l'électrolyte 106 peut être à base de LiPON ou de LiPONS ou de LiSiPON, ou de LiSON, ou de LiBSO, ou de LiViSiO, ou de Thio-LiSiCON, ou de Li₂O-Al₂O₃-TiO₂-P₂O₅.

L'épaisseur de l'électrolyte 106 est choisie de manière à être étanche au passage des électrons, mais suffisamment faible pour ne pas opposer de résistance trop importante au passage des ions. L'épaisseur de la couche 106 d'électrolyte peut être par exemple comprise entre 10 nanomètres et 200 nanomètres ou peut être par exemple de l'ordre de 100 nanomètres.

Des couches de collecteur de courant 108, 110 peuvent être également prévues. La cellule peut être formée d'une première couche 108 de collecteur en contact avec la première couche active 102, et à base d'un matériau conducteur de l'électricité, qui peut être un matériau métallique tel que par exemple du Ni.

Une deuxième couche 110 de « collecteur » en contact avec la deuxième couche active 104 peut être également prévue. Ces couches 108, 110 peuvent avoir une épaisseur comprise par exemple entre 10 nm et 100 nm.

Comme cela a été indiqué plus haut, le dispositif comprend également des moyens 112 générateurs de courant, aptes à émettre des impulsions de courant vers la première couche active 102 et/ou vers la deuxième couche active 104, pour permettre un échange d'espèce ionique entre les couches actives 102 et 104 et un basculement de la cellule mémoire d'un état donné vers un autre donné.

Le dispositif comprend également des moyens 114 de mesure connectés à la première couche active 102 et à la deuxième couche active 104, aptes à mesurer une différence de potentiel électrochimique entre ladite première couche active 102 et ladite deuxième couche active 104. Cette différence de potentiel électrochimique peut être déterminée par une mesure de différence de potentiel entre les couches actives 102 et 104. Les moyens 114 de mesure peuvent permettre de déterminer l'état dans lequel se trouve la cellule mémoire.

La cellule mémoire non volatile est susceptible d'adopter au moins deux états distincts dont un premier état ou état '1' pour lequel la première couche active 102 et la deuxième couche active 104 ont des compositions en espèce ionique respectives données, et un autre état '0' pour lequel la première couche active 102 et la deuxième couche active 104 ont des compositions respectives en espèce ionique différentes desdites compositions données.

Dans le cas, par exemple, où les couches actives 102, 104, sont à base d'un oxyde de métal de transition lithié, une variation de concentration en ions lithium de l'ordre de 10 % dans les couches actives 102 et 104 peut être suffisant pour permettre de traduire le basculement d'un premier état '1' ou '0' à un deuxième état, '0' ou '1', de la cellule mémoire.

Les impulsions de courant émises par les moyens 112 générateurs de courant peuvent être des impulsions d'intensité faible comprises par exemple entre 10⁻⁹ A et 10⁻⁶ A pendant une durée par exemple comprise entre 1 ns et 1 s. Une impulsion d'intensité de l'ordre de 10⁻⁷ A pendant une durée de l'ordre d'une seconde peut être émise par exemple pour faire basculer la cellule mémoire d'un état 'l' à un état '0' ou inversement.

Les moyens 112 générateurs de courant, peuvent être prévus pour émettre une impulsion de courant d'intensité donnée à l'empilement pour faire basculer la cellule d'un premier état, '1' (« haut ») ou '0' (« bas »), à un deuxième état '0' ou '1' eut également une impulsion de courant opposée, vers la deuxième couche active 104, d'intensité égale à l'intensité donnée pour faire basculer la cellule du deuxième état '0' ou '1' au premier état '1' ou '0'.

Le dispositif peut comprendre également des moyens 114 connectés à la première couche active 102 et à la deuxième couche active 104, aptes à mesurer une différence de potentiel électrochimique entre ladite première couche active 102 et ladite deuxième couche active 104. Cette différence de potentiel électrochimique peut être déterminée par une mesure de différence potentielle entre les couches actives 102 et 104. Les moyens 114 de mesure permettent de déterminer l'état dans lequel se trouve la cellule mémoire.

Plus généralement, les impulsions de courant émises par les moyens générateurs 112 sont prévues pour avoir une intensité suffisante pour faire basculer la cellule mémoire d'un premier état '0' à un deuxième état '1' où éventuellement d'un état '1' à un état '0'. L'état '1' de la mémoire est un état associé à une première valeur de différence de potentiels électrochimiques entre la première couche active 102 et la deuxième couche active 104 ou une première gamme de valeurs de différences de potentiels électrochimiques entre la première couche active 102 et la deuxième couche active 104. L'état '0' de la mémoire est un état associé à une deuxième valeur de différence de potentiels électrochimiques entre la première couche active 102 et la deuxième couche active 104 ou à une deuxième gamme de valeurs de différences de potentiels électrochimiques entre la première couche active 102 et la deuxième couche active 104. Ladite deuxième valeur est différente de la première valeur ou lesdites valeurs de ladite deuxième gamme sont différentes des valeurs de ladite première gamme.

Le fonctionnement d'un exemple de cellule mémoire non-volatile suivant l'invention, comprenant une première couche active 102 à base de LiMn₂O₄, et une deuxième couche active 104 à base de Li_{0.5}FePO₄, va à présent être donné

Le LiMn₂O₄ en tant que matériau de la première couche active 102 et le Li_{0.5}FePO₄ en tant que matériau de la deuxième couche active 104 ont été choisis selon des critères indiqués plus haut.

Le matériau LiMn₂O₄ de la couche 102 présente un potentiel électrochimique à l'équilibre de l'ordre de 3 Volts (exprimée par rapport au couple Li/Li+ au même titre que les autres valeurs de potentiel données par la suite) tandis que le matériau Li_{0.5}FePO₄ de la couche 104 présente un potentiel électrochimique à l'équilibre de l'ordre de 3,45 Volts. Le système présente à ses bornes une tension égale à environ 3 - 3,45 Volts soit de l'ordre de -0,45 Volts.

Etant données les propriétés des matériaux 103 et 105 choisis pour former les couches actives 102 et 104, une telle cellule est telle que si l'on interpose une résistance entre les bornes extérieures de cette dernière, aucune charge ionique ne peut être échangée à travers l'électrolyte car le potentiel de l'électrode contenant Li_{0.5}FePO₄ n'est pas suffisamment élevé pour extraire des ions lithium de l'électrode contenant LiMn₂O₄. Si ladite résistance interposée entre les bornes du système est suffisamment élevée (on entend ici par suffisamment élevée qu'elle correspond à celle d'un instrument de mesure tel qu'un voltmètre), aucune charge ne s'écoule spontanément dans cette résistance. Si l'on coupe l'alimentation de cette cellule, la cellule reste dans le même état qu'avant extinction.

Dans le présent exemple, il n'y a pas d'extraction d'ion lithium des sites octaédriques du composé LiMn₂O₄ au-dessous d'un potentiel voisin de 3,7 Volts. Sans échange d'ion lithium, aucun courant ionique ne circule à l'intérieur du dispositif. Si la résistance interposée entre les bornes extérieures du circuit est suffisamment élevée le système reste bloqué au voisinage de la valeur -0,45 Volts, même si l'alimentation de la cellule est éteinte. En présence d'une résistance interposée entre les bornes extérieures de la cellule, le potentiel entre les deux électrodes 102 et 104 évolue vers une valeur non nulle et mesurable.

Un premier potentiel non-nul de l'ordre de -0,45 Volt ou compris entre -0,45 V et -0,1 V peut être ainsi lu dans la cellule.

On peut considérer, par exemple, qu'une valeur comprise entre -0.45 V et -0.1 V de différence de potentiels indiquée plus haut entre les deux électrodes constitue un premier état, par exemple un état '1' (« haut ») pour la cellule mémoire.

En partant de cet état du système, appelé premier état, considérons maintenant la situation dans laquelle on impose le passage d'une faible quantité ε d'ions Lithium Li+ de la première électrode 102 à base de LiMn₂0₄ vers la 2^{ème} électrode 104 à base de Li_{0.5}FePO₄. L'imposition d'une faible impulsion de courant grâce au générateur de courant 112 permet un échange d'une faible quantité d'espèce chargée εLi+ entre les deux électrodes ci-dessus. Ladite impulsion a une durée et une amplitude adaptées notamment en fonction de l'épaisseur des électrodes.

Au niveau de la première électrode 102, une première réaction (1) se produit :

LiMn₂O₄ - ε Li⁺ => Li_{1-ε}Mn₂O₄ (1).

Le potentiel de la première électrode 102 est susceptible de passer d'environ 3 Volts pour la composition LiMn₂O₄ à 3,7 Volts environ dès l'extraction du 1^{er} ion lithium. La première électrode 102 contient alors du Li_{1-ε}Mn₂O₄ .

Au niveau de la deuxième électrode 104, le matériau à base de Li_{0.5}FePO₄ capte les ions lithium libérés par la première électrode 102 selon une réaction (2) suivante :

Li_{0.5}FePO₄ + εLi⁺ => Li_{0.5+ε}FePO₄ (2) .

La deuxième électrode 104 se retrouve formée d'un mélange de composition Li_{0.5+ε}FePO₄. Le potentiel de la deuxième électrode 104 reste égal à 3,45 Volts. La différence de potentiel entre les deux électrodes 102 et 104 est désormais égale à 3,7 Volts - 3,45 Volts = 0,25 Volts.

Lorsque l'alimentation du circuit mémoire comprenant une telle cellule est éteinte, la cellule voit à ses bornes une résistance non-nulle.

Lorsqu'une résistance non nulle est interposée aux bornes de la cellule, du fait de la différence de potentiel entre les deux électrodes 102 et 104, le matériau Li_{0.5+ε}FePO₄ de la première électrode 102 peut avoir spontanément tendance à céder une quantité α d'ions lithium qu'il contient au matériau Li_{1-ε}Mn₂O₄ de la deuxième électrode 104.

Une réaction globale (3) peut alors se produire :

Li_{0.5+ε}FePO₄ + Li_{1-ε}Mn₂O₄ => Li_{0.5+ε-α}FePO₄ + Li_{1-ε+α}Mn₂O₄ (3)

Avec α ≤ ε.

Lorsque tous les sites octaédriques du matériau Li_{1ε+a}Mn₂O₄ sont remplis, le potentiel de ce matériau est encore supérieur à 3,45 Volts. Aucun site tétraédrique vacant n'est plus disponible à 3,45 Volt. Les sites tétraédriques ne peuvent commencer à être remplis que si le potentiel imposé à ce matériau est voisin de 3 Volts. Or, ce potentiel d'électrode ne peut être atteint spontanément, conformément aux lois de la thermodynamique.

A l'issue de la réaction, le matériau Li_{1-ε+α}Mn₂O₄ présente l'ensemble de ses sites octaédriques remplis, et le potentiel de la première électrode présente un potentiel électrochimique voisin de 3,7 Volts.

Lorsque les deux électrodes 102 et 104 sont reliées par une résistance non-nulle, compte tenu des compositions des électrodes, les potentiels de celles-ci s'équilibrent spontanément à une valeur comprise entre 3,45 Volts et 3,7 Volts. Un autre état, compris entre 0,25 volts et 0 Volt peut former le deuxième état de la mémoire.

Le matériau LiMn₂O₄ a tendance à céder ses électrons et ses ions au matériau oxydant Li_{0.5}FePO₄. Cette captation n'est possible que lorsque le potentiel du matériau oxydant est suffisamment élevé pour atteindre le potentiel auquel le matériau réducteur est prêt à céder ses ions et ses électrons. Le matériau LiMn₂O₄ ne commence à céder ses ions et ses électrons qu'au voisinage de 3,7 Volts. Ce potentiel étant plus élevé que le potentiel du matériau LiFePO₄, le matériau LiMn₂O₄ ne peut céder ses ions et le système se retrouve bloqué dans un état que l'on a appelé « premier état ».

Lorsqu'on impose une impulsion de courant de manière à effectuer un échange de εLi⁺ entre les électrodes, le matériau LiMn₂O₄ atteint alors la composition Li_{1-ε}Mn₂O₄, tandis que le potentiel de l'autre électrode à base de Li₀,_{5+ε}FePO₄ ne change pas. On se retrouve dans une situation inverse de celle du premier état : le matériau initialement réducteur a vu son potentiel grimper et est passé au rôle d'oxydant par rapport à l'autre matériau. Le potentiel du Li_{1-ε}Mn₂O₄ (3,7 V) est plus élevé que celui du matériau Li₀,_{5+ε}FePO₄ (3,45 V). Par rapport au 1^{er} état, le potentiel de Li₀,_{5+ε}FePO₄ est cette fois suffisamment bas pour que le composé le plus oxydant, c'est-à-dire Li_{1-ε}Mn₂O₄ capte spontanément des électrons et des ions du matériau Li_{0,5+ε}FePO₄ jusqu'à atteindre spontanément un équilibre lorsque les deux composés sont quasiment au même potentiel, voisin de 0 Volt. Dans cette situation, les compositions sont devenues voisines de celles indiquées plus haut :

Li_{0,5+ε-α}FePO₄ et Li_{1-ε+α}Mn₂O₄ (3)

Avec α ≤ ε.

Il est alors possible de revenir au premier état du système en imposant une autre impulsion, opposée à la première impulsion de courant entre les bornes du système qui va permettre de finir de « vider » le matériau Li_{ε-α}FePO₄ de la deuxième électrode du lithium qu'il contient encore pour atteindre la composition Li₀,₅FePO₄, lorsque α = ε.

La composition de la première électrode est alors égale à LiMn₂O₄, et la différence de potentiel aux bornes du système revient à -0,45 Volts.

Une très faible quantité de matériau de la première couche active peut suffire à imposer le potentiel de l'électrode. Ainsi, la première électrode peut être de taille réduite. Cette particularité peut conduire à la mise en oeuvre de mémoires de taille extrêmement réduites. Prenons à nouveau un exemple de couche active 102 à base de LiMn₂O₄ et la réaction suivante :

LiMn₂O₄ - ε Li⁺ => Li_{1-ε}Mn₂O₄.

L'extraction d'une mole d'ions lithium Li⁺ (ε = 1) peut conduire à vider complètement une mole de matériau de la couche active, du lithium que ce matériau contient.

L'extraction d'un dixième de mole d'ions lithium Li⁺ (ε = 0,1) peut suffire à faire s'élever le potentiel de la couche active à une valeur voisine de 3,7 Volts (mesurée par rapport à une électrode référence de Li). La masse molaire du composé LiMn₂O₄ est égale à environ 180 grammes. L'extraction complète d'une mole de lithium contenu dans une mole de matériau LiMn₂O₄ correspond à l'échange d'une mole d'électrons dans un circuit extérieur au système, soit à l'échange de 96500 Ampère*seconde. La quantité d'électricité nécessaire pour vider complètement 1 gramme de matériau du lithium qu'il contient peut donc être égale à 96500x10³/3600x180 = 148 mAh.

Considérons, à titre d'exemple, un point mémoire de la forme d'un cube de dimensions : 1 µm x 1 µm x 1 µm. La masse volumique du composé LiMn₂O₄ étant voisine de 3,5, la masse approximative de matériau mis en jeu si l'électrode active représente la moitié du volume total du point mémoire peut être de l'ordre de 1,75 x 10⁻¹² grammes. La quantité d'électricité nécessaire pour extraire la totalité du lithium contenu dans cette quantité de matière peut être égale à 9,36*10⁻⁷ ampère*seconde.

Un tel calcul, donné à titre d'exemple, montre qu'une impulsion de courant de l'ordre de 10⁻⁷ ampères pendant une seconde peut suffire à faire basculer complètement l'état dudit point mémoire.

La quantité d'électricité nécessaire pour extraire suffisamment de lithium d'une couche active de manière à faire varier le potentiel de cette couche active peut même être encore dix fois plus faible que celle donnée plus haut, soit de l'ordre de 10 nanoampère pendant 1 seconde. Ainsi une très faible quantité de courant échangée peut suffire à faire basculer complètement le potentiel d'électrode de la première électrode.

On peut prévoir l'épaisseur des électrodes, et en particulier l'épaisseur de l'électrode 102 pour qu'une quantité de courant prédéterminée que l'on ne souhaite pas dépasser, par exemple pour des contraintes de consommation, permette d'extraire de l'ordre de 10 % de lithium de l'électrode 102.

Un exemple de procédé de fabrication d'un empilement d'une cellule mémoire suivant l'invention, va à présent être donné.

On réalise tout d'abord la première couche 102 de la première électrode active. Le matériau actif de cette première couche 102 peut être par exemple du LiMn₂O₄ formé à partir d'une poudre de granulométrie contrôlée dont les dimensions peuvent être de l'ordre du micron ou de la dizaine de microns. Cette poudre peut être ensuite frittée et peut être utilisée comme cible dans un dispositif de dépôt physique en phase vapeur (ou PVD pour « Physical Vapour Deposition »). La première couche 102 peut être déposée sur une couche 108 conductrice électronique qui peut être à base d'un matériau métallique par exemple tel que du nickel. La couche 108 conductrice électronique est destinée à former un premier collecteur de courant. Selon une variante, on peut former la première couche 102 selon des procédés usuellement utilisés pour la réalisation d'électrodes d'accumulateurs au lithium tel que décrit dans Journal of Power Sources, 1993, 44(1-3) : p.689-700.

Ensuite, on forme une couche 106 d'électrolyte sur la première couche 102 active. La couche d'électrolyte peut être réalisée par dépôt physique en phase vapeur d'un matériau conducteur ionique et isolant électronique, par exemple un verre de type « Lipon^{®}» ou de composition : 1B₂O₃-0,8Li₂O-0,8Li₂SO₄. Selon d'autres exemples, l'électrolyte 106 peut être à base de LiPON ou de LiPONS ou de LiSiPON, ou de LiSON, ou de LiBSO, ou de LiViSiO, ou de Thio-LiSiCON, ou de Li₂O-Al₂O₃-TiO₂-P₂O₅.

La deuxième couche active 104 est ensuite déposée sur la couche d'électrolyte 106, en utilisant, par exemple, le même procédé que pour la première couche 102 active. La deuxième couche active 104 peut être formée par exemple à base de LiFeP04, par exemple par PVD. Il est également possible de réaliser la deuxième couche active 104 par dépôt direct d'une couche formée en mélangeant une poudre avec un liant par exemple de type PVDF (PVDF pour polymère du fluorure de vinylidène) habituellement utilisé dans l'industrie des accumulateurs, puis dépôt par enduction des matériaux sur un substrat conducteur (feuille métallique de Nickel, par exemple). Le dépôt obtenu peut être ensuite poli de manière à obtenir une électrode d'épaisseur très fine, inférieure au micron, par exemple comprise entre 10 et 100 nanomètres.

On réalise ensuite le dépôt d'une couche 110 conductrice électronique, par exemple par un dépôt de type dépôt physique en phase vapeur (PVD), par exemple à base de nickel, destiné à former un deuxième collecteur de courant.

Ensuite, une encapsulation de l'ensemble peut être réalisée afin d'assurer la protection du dispositif. L'encapsulation peut être réalisée, par exemple à l'aide d'un enrobage dans une résine. Les matériaux actifs d'électrode peuvent être stables à l'oxygène. Les matériaux utilisés pour mettre en oeuvre un dispositif de mémoire suivant l'invention s'adaptent aux techniques de réalisation en couches minces utilisées en microélectronique.

L'invention trouve des applications dans de nombreux domaines, par exemple celui des puces à mémoire multiple dans des terminaux mobiles tels que les téléphones portables, les réseaux de mémoires, les mémoires dites « enfouies » (« embedded » selon la terminologie anglo-saxonne).

Le dispositif de mémoire électrochimique suivant l'invention présente une faible consommation, une sensibilité et une rapidité importante, une bonne stabilité des électrodes dans le temps.

Une cellule mémoire suivant l'invention présente également une bonne réversibilité, le passage d'un état '1' à un état '0' et d'un état '0' à un état '1' pouvant être provoqué respectivement à l'aide d'une première impulsion de courant et d'une deuxième impulsion de courant opposée à la première impulsion.

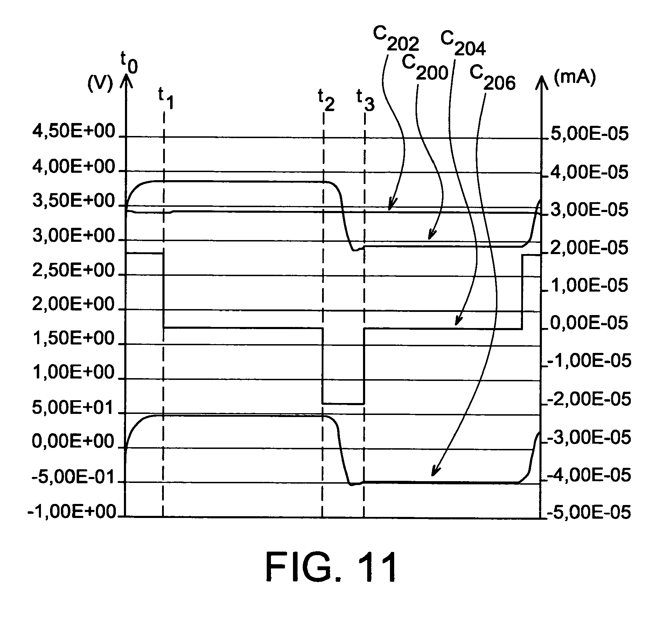

Sur la figure 11, des courbes C₂₀₀, C₂₀₂, C₂₀₄ illustrent le fonctionnement d'un exemple de cellule mémoire, formée avec une première couche active 102 à base de LiMn₂O₄ et une deuxième couche active 104 à base de Li_{0,5}FePO₄, et des couches collectrices 108 et 110 à base de Nickel.

Cette cellule a été formée avec des électrodes 102 et 104 de dimensions typiques de 14 mm de diamètre et de l'ordre de 100 µm d'épaisseur, tandis que la quantité des matériaux 103 et 105 qu'elles contiennent est voisine de 500 mg. Leur comportement traduit néanmoins le comportement d'un système réalisé à l'échelle nanoscopique.

Ces courbes C₂₀₀, C₂₀₂, C₂₀₆ donnent des évolutions de potentiel aux bornes de chaque sous-système ainsi qu'aux bornes du système complet lorsqu'on soumet cette mémoire à un courant (courbe C₂₀₄) au cycle suivant :
1) entre un instant t₀ et un instant t₁ : un courant de +20 µA pendant 30 minutes,
2) entre un instant t₁ et un instant t_{2 :} un courant nul pendant 2 heures,
3) entre un instant t₂ et un instant t₃, un courant de -20 µA pendant 30 minutes,
4) entre un instant t₃ et un instant t₄ un courant nul pendant 2 heures.

La courbe C₂₀₆ est représentative de mesures de l'évolution avec le temps d'un potentiel aux bornes de l'empilement complet.

La courbe C₂₀₂ est représentative de mesures de l'évolution avec le temps du potentiel aux bornes de : l'empilement Lithium/électrolyte/Li_{0,5}FePO₄.

La courbe C₂₀₀ est représentative de mesures de l'évolution avec le temps du potentiel aux bornes de l'empilement : LiMn₂O_{4/}électrolyte/Lithium.

Le potentiel du sous-système Lithium/électrolyte/Li_{0,5}FePO₄ reste stable, tandis que celui du sous-système LiMn₂O₄/électrolyte/Lithium bascule à chaque inversion de courant pour rester stable de part et d'autre du potentiel du sous-système Lithium/électrolyte/Li_{0,5}FePO₄.

## Revendications

1. Dispositif de mémoire non-volatile (100) comprenant :
- un empilement de couches comportant un électrolyte (106),
- des moyens générateurs (112) aptes à appliquer au moins une quantité d'électricité donnée à cet empilement de couches, le dispositif étant **caractérisé en ce que** l'empilement comporte de part et d'autre dudit électrolyte :
- au moins une première couche active (102) à base d'un premier matériau (103) cristallin conducteur ionique et électronique, apte à libérer et/ou accepter au moins une espèce ionique, et dont le potentiel électrochimique est susceptible de subir, suite à une injection de ladite quantité d'électricité donnée dans ledit empilement, au moins une première variation donnée entre au moins une première valeur et au moins une deuxième valeur,
- au moins une deuxième couche active (104) à base d'un deuxième matériau (105) cristallin conducteur ionique et électronique, apte à libérer et/ou accepter au moins une espèce ionique, et dont le potentiel électrochimique susceptible de subir, suite à une injection de ladite quantité d'électricité donnée dans ledit empilement, au moins une deuxième variation entre au moins une troisième valeur et au moins une quatrième valeur, ladite deuxième variation étant plus faible que ladite première variation, ladite troisième valeur et ladite quatrième valeur étant comprises entre ladite première valeur et à ladite deuxième valeur.

2. Dispositif de mémoire non-volatile selon la revendication 1, le premier matériau (103) et le deuxième matériau (105) étant des matériaux d'intercalation du lithium.

3. Dispositif de mémoire non-volatile selon la revendication 2, dans lequel les moyens générateurs (112) sont prévus pour appliquer des impulsions de courant audit empilement selon une quantité d'électricité donnée comprise entre 10 µA*nanosecondes et 500 µA*nanosecondes.

4. Dispositif de mémoire non-volatile selon l'une des revendications 1 à 3, dans lequel la deuxième variation est faible ou nulle, la première variation étant importante.

5. Dispositif de mémoire non-volatile selon l'une des revendications 1 à 4, dans lequel la quantité d'électricité donnée est comprise entre 10 µA*nanosecondes et 500 µA*nanosecondes, la deuxième couche active (104) étant à base d'un matériau (105) susceptible de présenter une variation de potentiel inférieure ou égale à 1 mV ou à 30 mV.

6. Dispositif de mémoire non-volatile selon l'une des revendications 1 à 5, la deuxième couche active (104) étant à base d'un matériau (105) Liₓ₂M' _{y2}O_{z2}, avec M' un élément métallique, et susceptible de présenter une variation de potentiel inférieure ou égale à 1 mvolt ou à 30 mvolts pour une variation de la proportion x2/y2 de Li par rapport à M' dans le Liₓ₂M'_{y2}O_{z2} comprise entre 1 % et 10 %.

7. Dispositif de mémoire non-volatile selon l'une des revendications 1 à 6, dans lequel la quantité d'électricité donnée est comprise entre 10 µA*nanosecondes et 500 µAnanosecondes, la première couche active (102) étant à base d'un matériau (103) susceptible de présenter une variation de potentiel d'au moins 0,1 volts ou 0,2 volts ou comprise entre 0,1 volts et 0,4 volts.

8. Dispositif de mémoire non-volatile selon l'une des revendications 1 à 7, la première couche active (102), étant à base d'un matériau (103) Liₓ₁M_{y1}O_{z1} et susceptible de présenter une variation de potentiel supérieure ou égale à 0,1 1 volts ou à 0,2 volts ou comprise entre 0,1 1 et 0,4 volts, pour une variation de la proportion x1/y1 de Li par rapport à M dans le Liₓ₁M_{y1}O_{z1} comprise entre 1 % et 10 %.

9. Dispositif de mémoire selon l'une des revendications 1 à 8, dans lequel ladite première couche active (103) a un volume compris entre 3,125*10⁻⁴ µm³ et 0,1 µm³.

10. Dispositif de mémoire selon l'une des revendications 1 à 9, dans lequel ladite deuxième couche active (104) a un volume compris entre 3,125*10⁻⁴ µm³ et 0,1 µm³.

11. Dispositif de mémoire selon l'une des revendications 1 à 10, le premier matériau (103) étant à base d'un composé de type spinelle tel que du LiMn₂O₄ ou du LiNi_{0.5}Mn_{1.5}O₄.

12. Dispositif de mémoire non volatile selon l'une des revendications 1 à 10, le premier matériau (103) étant à base d'un composé de type olivine tel que du LiₓFe₁₋ₓMnₓPO₄ ou du LiₓFe₁₋ₓCoₓPO₄.

13. Dispositif de mémoire non volatile selon l'une des revendications 1 à 10, le premier matériau (103) étant à base d'un mélange d'au moins un composé sous forme réduite et d'au moins un composé sous forme oxydée.

14. Dispositif de mémoire non volatile selon la revendication 13, le premier matériau (103) étant à base d'un mélange de α·LiFePO₄ et de 1-α·LiTiCrO₄ ou d'un mélange de α·LiFePO₄ et de 1-α·Li_{4/3}Ti_{5/3}O₄ ou d'un mélange de α·LiVPO₄F et 1-α·Li_{4/3}Ti_{5/3}O₄ ou d'un mélange de α·LiVPO₄F et de 1-α·Fe₂(MoO₄)₃; ou d'un mélange de α·LiNi_{0.5}Mn_{1.5}O₄ et 1-α·εVOPO₄.

15. Dispositif de mémoire selon l'une des revendications 1 à 10, le premier matériau (103) étant à base de LiNi_{0.5}Mn_{1.5}O₄, le deuxième matériau (105) étant à base de Li₁₋ₓVOPO₄F ou de Li₁₋ₓFePO₄.

16. Dispositif de mémoire selon l'une des revendications 1 à 10, le premier matériau (103) étant à base de Life₁₋ₓCoₓPO₄, avec x ≠ 0, le deuxième matériau (105) étant à base de Li₁₋ₓVOPO₄F.

17. Dispositif de mémoire selon l'une des revendications 1 à 10, le premier matériau (103) étant à base d'un mélange de LiFePO₄ et de Li₄Ti₅O₁₂, le deuxième matériau (105) étant à base de α·Fe₂(MoO₄)₃.

18. Dispositif de mémoire selon l'une des revendications 1 à 17, comprenant en outre, au moins une couche (108) métallique en contact avec la première couche active (102) et/ou au moins une autre couche (110) métallique en contact avec la deuxième couche active (104).

19. Dispositif de mémoire selon l'une des revendications 1 à 18, comprenant en outre : des moyens de mesure (114) de la différence de potentiel électrochimiques entre ladite première couche active et de ladite deuxième couche active.

## Claims

1. Non-volatile memory device (100) comprising:
- a stack (106) of layers comprising an electrolyte;
- generating means (112) suited to applying at least one given quantity of electricity to said stack of layers, said device being **characterized in that** it comprises, on either side of said electrolyte:
- at least one first active layer (102) based on a first ion and electron conductor crystalline material (103), suited to releasing and/or accepting at least one ion species, and the electrochemical potential of which is capable of undergoing, following an injection of said given quantity of electricity into said stack, at least one first given variation between at least one first value and at least one second value,
- at least one second active layer (104) based on a second ion and electron conductor crystalline material (105), suited to releasing and/or accepting at least one ion species, and the electrochemical potential of which is capable of undergoing, following an injection of said given quantity of electricity into said stack, at least one second variation between at least one third value and at least one fourth value,
said second variation being lower than said first variation, said third value and said fourth value being between said first value and said second value.

2. Non-volatile memory device according to claim 1, the first material (103) and the second material (105) being lithium intercalation materials.

3. Non-volatile memory device according to claim 2, in which the generating means (112) are provided to apply current pulses to said stack according to a given quantity of electricity between 10 µA*nanoseconds and 500 µA*nanoseconds.

4. Non-volatile memory device according to one of claims 1 to 3, in which the second variation is low or zero, the first variation being sizeable.

5. Non-volatile memory device according to one of claims 1 to 4, in which the given quantity of electricity is between 10 µA*nanoseconds and 500 µA*nanoseconds, the second active layer (104) being based on a material (105) capable of having a variation in potential less than or equal to 1 mV or 30 mV.

6. Non-volatile memory device according to one of claims 1 to 5, the second active layer (104) being based on a material (105) Liₓ₂M'_{y2}O_{z2} (where M' is a metal element) and capable of having a variation in potential less than or equal to 1 mvolt or 30 mvolts for a variation in the proportion x2/y2 of Li compared to M' in Liₓ₂M'_{y2}O_{z2} between 1 % and 10 %.

7. Non-volatile memory device according to one of claims 1 to 6, in which the given quantity of electricity is between 10 µA*nanoseconds and 500 µA*nanoseconds, the first active layer (102) being based on a material (103) capable of having a variation in potential of at least 0.1 volts or 0.2 volts or between 0.1 volts and 0.4 volts.

8. Non-volatile memory device according to one of claims 1 to 7, the first active layer (102), being based on a material (103) Liₓ₁My₁O_{z1} and capable of having a variation in potential greater than or equal to 0.1 volts or 0.2 volts or between 0.1 and 0.4 volts, for a variation in the proportion x1/y1 of Li compared to M in Liₓ₁M_{y1}O_{z1} between 1 % and 10 %.

9. Memory device according to one of claims 1 to 8, in which said first active layer (103) has a volume between 3.125*10⁻⁴ µm³ and 0.1 µm³.

10. Memory device according to one of claims 1 to 9, in which said second active layer (104) has a volume between 3.125*10⁻⁴ µm³ and 0.1 µm³.

11. Memory device according to one of claims 1 to 10, the first material (103) being based on a spinel type compound such as LiMn₂O₄ or LiNi_{0.5}Mn₁.₅O₄.

12. Non-volatile memory device according to one of claims 1 to 10, the first material (103) being based on an olivine type compound such as LiₓFe₁₋ₓMnₓPO₄ or LiₓFe₁₋ₓCoₓPO₄.

13. Non-volatile memory device according to one of claims 1 to 10, the first material (103) being based on a mixture of at least one compound in reduced form and at least one compound in oxidized form.

14. Non-volatile memory device according to claim 13, the first material (103) being based on a mixture of α·LiFePO₄ and 1-α·LiTiCrO₄ or a mixture of α·LiFePO₄ and 1-α·Li_{4/3}Ti_{5/3}O₄ or a mixture of α·LiVPO₄F and 1-α·Li_{4/3}Ti_{5/3}O₄ or a mixture of α·LiVPO₄F and 1-α·Fe₂(MoO₄)₃ or a mixture of α·LiNi_{0.5}Mn_{1.5}O₄ and 1-α·εVOPO₄.

15. Memory device according to one of claims 1 to 10, the first material (103) being based on LiNi_{0.5}Mn_{1.5}O₄, the second material (105) being based on Li₁₋ₓVOPO₄F or Li₁₋ₓFePO₄.

16. Memory device according to one of claims 1 to 10, the first material (103) being based on LiFe₁₋ₓCoₓPO₄ (where x ≠ 0), the second material (105) being based on Li₁₋ₓVOPO₄F.

17. Memory device according to one of claims 1 to 10, the first material (103) being based on a mixture of LiFeP0₄ and Li₄Ti₅O₁₂, the second material (105) being based on α·Fe₂(MoO₄)₃.

18. Memory device according to one of claims 1 to 17, further comprising at least one metal layer (108) in contact with the first active layer (102) and/or at least one other metal layer (110) in contact with the second active layer (104).

19. Memory device according to one of claims 1 to 18, further comprising: means of measuring (114) the difference in electrochemical potential between said first active layer and said second active layer.

## Patentansprüche

1. Nicht-flüchtige Speichervorrichtung (100) umfassend
- einen Stapel (106) von Schichten mit einem Elektrolyten,
- Generatormittel (112), die dem Schichtstapel wenigstens eine gegebene Elektrizitätsmenge zuführen können,
die Vorrichtung **dadurch gekennzeichnet, dass** der Stapel beidseits des genannten Elektrolyten umfaßt:
- wenigstens eine erste aktive Schicht (102) auf der Basis eines ersten kristallinen, ionisch und elektronisch leitenden Materials, das wenigstens eine lonenart freisetzen und/oder aufnehmen kann und dessen elektrochemisches Potential als Folge einer Injektion der genannten gegebenen Elektrizitätsmenge in den Stapel wenigstens eine erste gegebene Änderung zwischen wenigstens einem ersten Wert und wenigstens einem zweiten Wert erfahren kann,
- wenigstens eine zweite aktive Schicht (104) auf der Grundlage eines zweiten kristallinen, ionisch und elektronisch leitenden Materials (105), das wenigstens eine Ionenart freisetzen und/oder aufnehmen kann und dessen eletrochemisches Potential infolge einer Injektion der genannten gegebenen Elektrizitätsmenge in den Stapel wenigstens eine zweite Änderung zwischen wenigstens einem dritten Wert und wenigstens einem vierten Wert erfahren kann, wobei die zweite Änderung schwächer als die erste Änderung ist und der dritte Wert und der vierte Wert zwischen dem genannten ersten Wert und dem genannten zweiten Wert liegen.

2. Nicht-flüchtige Speichervorrichtung nach Anspruch 1, bei welcher das erste (103) und das zweite (105) Material Lithium-Einbaumaterialien sind.

3. Nicht-flüchtige Speichervorrichtung nach Anspruch 2, bei welcher die Generatormittel (112) vorgesehen sind, um an den Stapel Stromimpulse gemäß einer gegebenen Elektrizitätsmenge anzulegen, welche im Bereich zwischen 10 µA* Nanosekunden und 500 µA*Nanosekunden liegen.

4. Nicht-flüchtige Speichervorrichtung nach einem der Ansprüche 1 bis 3, bei welcher die zweite Änderung klein ist oder Null beträgt, die erste Änderung hingegen bedeutsam ist.

5. Nicht-flüchtige Speichervorrichtung nach einem der Ansprüche 1 bis 4, bei welcher die gegebene Elektrizitätsmenge zwischen 10 A*nanosekun den und 500 µA*nanosekunden beträgt und die zweite aktive Schicht (104) auf der Basis eines Materials (105) ausgebildet ist, das eine Potentialänderung kleiner oder gleich 1 mV oder kleiner oder gleich 30 mV aufweisen kann.

6. Nicht-flüchtige Speichervorrichtung nach einem der Ansprüche 1 bis 5, bei welcher die zweite aktive Schicht (104) auf der Basis eines Materials (105) Liₓ₂ M'_{y2}Oₓ₂, mit M' als einem metallischen Element, ausgebildet ist und eine Potentialänderung kleiner oder gleich 1 mV oder 30 mV aufweisen kann, für eine Änderung des Verhältnisanteils x2/ y2 von Li relativ gegenüber dem M' in dem Liₓ₂ M'_{y2}Oₓ₂ im Bereich zwischen 1 % und 10%.

7. Nicht-flüchtige Speichervorrichtung nach einem der Ansprüche 1 bis 6, bei welcher die gegebene Elektrizitätsmenge einen Wert im Bereichzwischen 10 A*nanosekun den und 500 µA*nanosekunden besitzt und die erste aktive Schicht (102) auf der Grundlage eines Materials (103) ausgebildet ist, das eine Potentiafänderung von wenigstens
0,1 V oder 0,2 V aufweisen oder zwischen 0,1 V und 0,4 V betragen kann.

8. Nicht-flüchtige Speichervorrichtung nach einem der Ansprüche 1 bis 7, bei weiche die erste aktive Schicht (102) auf der Basis eines Materials (103) Liₓ₁ M'_{y1} O_{z1} ausgebildet ist und eine Potentialänderung größer oder gleich 0,1 V oder 0,2 V oder einen Wert im Bereich zwischen 0,1 V und 0,4 V aufweisen kann, für eine Änderung des Anteilverhältnisses x1/y1 von Li relativ bezüglich dem M in dem Liₓ₁ M'_{y1} O_{z1} im Bereich zwischen 1 % und 10 %.

9. Nicht-flüchtige Speichervorrichtung nach einem der Ansprüche 1 bis 8, bei welcher die genannte erste aktive Schicht (103) ein Volumen im Bereich zwischen 3,125* 10⁻⁴ µm³ und 0,1 µm³ besitzt.

10. Nicht-flüchtige Speichervorrichtung nach einem der Ansprüche 1 bis 9, , bei welcher die genannte zweite aktive Schicht (104) ein Volumen im Bereich zwischen 3,125* 10⁻⁴ µm³ und 0,1 µm³ besitzt.

11. Nicht-flüchtige Speichervorrichtung nach einem der Ansprüche 1 bis 10, bei welcher das erste Material (103) auf der Basis einer Verbindung vom Spinell-Typ wie beispielsweise LiMn₂ O₄ oder LiNi _{0,5} Mn _{1,5} O₄ gewählt ist.

12. Nicht-flüchtige Speichervorrichtung nach einem der Ansprüche 1 bis 10, bei welcher das erste Material (103) auf der Basis einer Verbindung vom Olivintyp wie beispielsweise LiₓFe _{1 -x} Mn_{X} PO₄ oder LiₓFe ₁₋ₓ Coₓ PO₄ gewählt ist .

13. Nicht-flüchtige Speichervorrichtung nach einem der Ansprüche 1 bis 10, bei welcher das erste Material (103) auf der Gruindlage eines Gemischs aus wenigstens einer Komponente in reduzierter Form und wenigstens einer Komponente in oxydierter Form gewählt ist.

14. Nicht-flüchtige Speichervorrichtung nach Anspruch 13, bei welcher das erste Material (103) auf der Basis einer Mischung von α.LiFePO₄ und von 1-α. LiTiCrO₄ oder einer Mischung von α.LiFePO₄ und von 1 α.Li _{4/3} Ti _{5/3} O₄,
oder einer Mischung von α.LiVPO₄F und 1-α.Li _{4/3} Ti _{5/3} O₄, oder einer Mischung von α.LiVPO₄F und von 1- α .Fe₂ (MoO₄)₃, oder einer Mischung von α.LiNi _{0,5} Mn _{1.5} O₄ und von 1. α VOPO₄ gewählt ist.

15. Nicht-flüchtige Speichervorrichtung nach einem der Ansprüche 1 bis 10, bei welcher das erste Material (103) auf der Basis von LiNi _{0,5} Mn _{1.5} O₄, das zweite Material (105) auf der Basis von Li _{1 -x} VOPO₄F oder von Li _{1 -x} FePO₄ gewählt sind.

16. Nicht-flüchtige Speichervorrichtung nach einem der Ansprüche 1 bis 10, bei welcher das erstee Material (103) auf der Basis von Li Fe _{1 -x} Co ₓ PO₄, mit x 0, das zweite Material (105) auf der Basis von Li _{1 x} VOPO₄F gewählt sind.

17. Nicht-flüchtige Speichervorrichtung nach einem der Ansprüche 1 bis 10, bei welcher das erste Material (103) auf der Basis einer Mischung von LiFePO₄ und von Li₄Ti₅O₁₂, das zweite Material (105) auf der Basis von α.Fe₂ (MoO₄)₃ gewählt sind.

18. Nicht-flüchtige Speichervorrichtung nach einem der Ansprüche 1 bis 17, welche des weiteren wenigstens eine metallische Schicht (108) in Kontakt mit der ersten aktiven Schicht (102) und/oder wenigstens eine andere metallische Schicht (110) in Kontakt mit der zweiten aktiven Schicht (104) umfaßt.

19. Nicht-flüchtige Speichervorrichtung nach einem der Ansprüche 1 bis 18, welche des weiteren Mittel (114) zum Messen der elektrochemischen Potentialdifferenz zwischen der genannten ersten aktiven und der genannten zweiten aktiven Schicht umfaßt.
